# EUROPÄISCHE PATENTSCHRIFT

(11) **EP 3 317 682 B1**
(45) Veröffentlichungstag und Bekanntmachung des Hinweises auf die Patenterteilung: **25.05.2022**
(21) Anmeldenummer: 16735614.6
(22) Anmeldetag: 30.06.2016
(51) Int. Cl.: G01R 31/28

(54) **SCHALTUNGSANORDNUNG ZUR ÜBERWACHUNG EINER FREILAUFDIODE**
CIRCUIT ARRANGEMENT FOR MONITORING A FLYBACK DIODE
ENSEMBLE FORMANT CIRCUIT POUR LA SURVEILLANCE D'UNE DIODE DE ROUE LIBRE

(30) Priorität: 02.07.2015 DE 102015110672
(43) Veröffentlichungstag der Anmeldung: 09.05.2018
(73) Patentinhaber: KNORR-BREMSE Systeme für Nutzfahrzeuge GmbH, 80809 München (DE)
(72) Erfinder: FEUCHT, Thomas, 71299 Wimsheim (DE)
(86) Internationale Anmeldenummer: PCT/EP2016/065269
(87) Internationale Veröffentlichungsnummer: WO 2017/001547

(56) Entgegenhaltungen:
- DE-A1- 10 201 453
- DE-A1- 19 941 489
- DE-A1-102004 007 209
- US-A- 5 909 353

## Beschreibung

Die Erfindung betrifft eine Schaltungsanordnung zur Überwachung einer Diode, und bezieht sich insbesondere auf eine Schaltungsanordnung zur Überwachung einer Freilaufdiode an mittels PWM angesteuerten Magnetventilen.

Freilaufdioden werden häufig zum Schutz vor Überspannungen beim Abschalten induktiver Gleichspannungslasten von Magnetventilen eingesetzt. Dazu wird eine Halbleiterdiode so parallel zum Magneten als einem induktiven Gleichstromverbraucher geschaltet, dass sie von der Speisespannung in Sperrrichtung beansprucht wird. Nach dem Abschalten der Speisespannung sorgt die Selbstinduktion der Spule dafür, dass der Strom zunächst in der ursprünglichen Richtung weiter fließt. Ohne Freilaufdiode führt dies zu einer Spannungsspitze, die sich zur Betriebsspannung addiert und die Schaltstrecke schädigen oder zerstören kann. Mit einer Freilaufdiode wird die Spannungsspitze jedoch auf die Durchlassspannung der Diode begrenzt, so dass elektronische Bauteile und Schaltkontakte wirksam vor Überspannung geschützt werden.

In beispielsweise einer elektro-pneumatischen Betriebsbremsanlage eines Nutzfahrzeugs erfolgt die Einsteuerung oder Einregelung von Betriebsbremsdrücken in Bremszylinder oder Radbremszylinder mittels einer zentralen elektronischen Steuereinrichtung, welche mit einem Luftvorrat und den Bremszylindern verbundene Magnetventile zum Belüften und Entlüften der Bremszylinder öffnet und schließt. Hierbei sind die Magnetventile als so genannte Backup-Magnetventile, Einlass-Magnetventile und Auslass-Magnetventile angeordnet und gesteuert. Mehrkanalige Ausgestaltungen sind in solchen Bremsanlagen inzwischen üblich, so dass die jeweiligen Ventile mehrfach und zumindest ein Relaisventil vorgesehen sind, welches eine beispielsweise seitenweise unabhängige Regelung der Bremsdrücke mittels dieser Magnetventile ermöglicht. Ferner ist in der Regel eine pneumatische Rückfallebene vorgesehen, welche im Falle einer elektrischen Störung aktiv wird und dann eine herkömmliche, pneumatisch gesteuerte Abbremsung ermöglicht. Dieses Rückfallsystem ist zweikreisig und bedient auch einen eventuell vorhandenen Anhänger, so dass auch im Störungsfall alle Räder gebremst werden können.

Bei der vorgenannten elektro-pneumatischen Betriebsbremsanlage werden bei einem Bremsvorgang sowohl die Backup-Magnetventile als auch die Einlass-Magnetventile bestromt, wobei nach Erreichen des von der zentralen elektronischen Steuereinrichtung berechneten Solldrucks in einem Belüftungsvorgang die Magnete der Einlass-Magnetventile abgeschaltet werden, die Magnete der Backup- Magnetventile aber weiter bestromt bleiben und der Druck in den Bremszylindern gehalten wird. Ändert sich gemäß einem Fahrerwunsch der Bremsvorgang, werden für einen Druckabbau in den Bremszylindern für einen Entlüftungsvorgang die Magnete der Auslass-Magnetventile durch die zentrale elektronische Steuereinrichtung abgesteuert, und können Drücke von den internen Steueranschlüssen des zumindest einen Relaisventils über die Auslass-Magnetventile abgebaut werden.

Eine Magnetventil-Treiberstufe einer zentralen elektronischen Steuereinrichtung kann bei mehrkanaliger Anordnung der Magnetventile in jedem Kanal für ein Einlass-Magnetventil, ein Auslass-Magnetventil und ein Backup-Magnetventil jeweils für jedes der Magnetventile einen hochpotenzialseitigen Schalter oder High-Side-Switch, jeweils einen für alle Magnetventile gemeinsamen niedrigpotenzialseitigen Schalter oder Low-Side-Switch, und jeweils eine gemeinsame Freilaufdiode beinhalten, die parallel zu Zweigen mit den hochpotenzialseitigen Schaltern und den Magneten der Magnetventile zwischen der Versorgungsspannung und einem gemeinsamen Knoten liegt. Insgesamt sind die einzelnen Kanäle im Wesentlichen gleich aufgebaut.

In einer grundlegenden Funktionsweise dieser Magnetventil-Treiberstufe wird mit dem gemeinsamen niedrigpotenzialseitigen Schalter mittels einer Pulsweitenmodulation (PWM) in Abhängigkeit von der Versorgungsspannung ein vorbestimmter Haltestrom für die Magnete der Magnetventile eingesteuert. Dann können die einzelnen Magnetventile über ihre zugeordneten hochpotenzialseitigen Schalter bedarfsweise und unabhängig voneinander aktiviert werden. Zum Beenden des aktivierten Zustands kann bei einem aktivierten hochpotenzialseitigen Schalter während der laufenden Pulsweitenmodulation die induktive Energie der Magnete der Magnetventile über die parallel liegende Freilaufdiode gelöscht werden. Darüber hinaus können die hochpotenzialseitigen Schalter über eine integrierte Strombegrenzungsfunktion verfügen, welche die zentrale elektronische Steuereinrichtung im Falle eines Windungsschlusses in einem Magnetventil vor dann auftretenden hohen Kurzschlussströmen schützt.

Im Bereich der elektro-pneumatischen Betriebsbremsanlagen und elektronischen Bremssysteme für Nutzfahrzeuge sind, beispielsweise auf der Grundlage gesetzgeberischer Maßnahmen und dergleichen, zunehmend zahlreichere Prüfmechanismen gefordert, in welchen Hard- und/oder Software-Komponenten auch während des Betriebs kontinuierlich auf Fehlerzustände überprüft werden. Im Rahmen solcher Prüfmechanismen für beispielsweise ein elektro-pneumatisches Modul eines elektronischen Bremssystems bzw. einer elektro-pneumatischen Betriebsbremsanlage für Nutzfahrzeuge wird bisher mittels einer Messung des durch ein in dem elektro-pneumatischen Modul verbautes Magnetventil fließenden Stroms auf korrekte Funktion des Moduls überwacht. Steigt der Ventilstrom in unerwünschter Weise an, wird auf einen Fehler in dem Modul geschlossen und werden entsprechende Maßnahmen zur beispielsweise Information des Fahrers und/oder eines Notbetriebs mit rein pneumatischem Bremsbetrieb gemäß Fahrerwunsch getroffen. Diese Art der Überwachung und Messung des Ventilstroms erfolgt analogseitig und erfordert einen niederohmigen Shunt hoher Leistung, einen Operationsverstärker auf der High-Seite, einen Stromspiegel und dergleichen, und ist entsprechend aufwändig. Nachteilig sind daher nicht nur der analogseitig hohe Schaltungsaufwand zur Realisierung der Ventilstrommessung, sondern auch damit verbunden hohe Kosten, die insbesondere bei hohen Stückzahlen standardkonformer Module die Gesamtkosten unerwünscht erhöhen.

Die Druckschrift US 5 909 353 A offenbart eine Schaltungsanordnung für Motorfahrzeuge zum unabhängigen Schalten der Induktionsspulen mehrerer gleichstrombetriebener und parallel geschalteter Solenoidventile, Die Schaltungsanordnung beinhaltet Sperrdioden und einen Freilaufkreis mit einer Freilaufdiode und einen MOSFET in Verbindung mit einer geeigneten Regelschaltung, die die Spannung an einem vorbestimmten Knotenpunkt überwacht und den MOSFET in die lineare Betriebsart steuert, wenn die Spannung an dem Knotenpunkt einen Schwellenwert überschritten hat und konstant bleibt.

Ferner offenbart die Druckschrift DE 199 41 489 A1 eine Schutzschaltung für eine Reihenschaltung aus Leistungshalbleiter-Endstufe und induktivem Verbraucher, bei der eine definierte Ansprechschwelle in einem Überwachungskreis durch Vergleichen einer Spannung an einem Pufferkondensator oder einer reduzierten Spannung in einem Komparator mit einer vorgegebenen Referenzspannung und Weiterleiten eines digitalen Abschaltsignals an eine PWM-Steuerung, wenn die Spannung am Pufferkondensator oder die reduzierte Spannung übersteigt, vorgesehen ist.

Vor diesem Hintergrund liegt der Erfindung als eine Aufgabe zugrunde, eine einfacher und kostengünstiger darzustellende Schaltungsanordnung zur Überwachung des Ventilstroms an einem durch Pulsweitenmodulation angesteuerten Magnetventil zu schaffen.

Darüber hinaus soll die Erfindung eine einfacher und kostengünstiger darzustellende Schaltungsanordnung zur Überwachung der korrekten Funktion eines elektro-pneumatischen Moduls in einem elektronischen Bremssystem eines Nutzfahrzeugs bereitstellen.

Darüber hinaus soll die erfindungsgemäße Schaltungsanordnung zu einer Eigenüberwachung seiner eigenen korrekten Funktion in der Lage sein.

Erfindungsgemäß wird diese Aufgabe durch eine Schaltungsanordnung mit den Merkmalen des Patentanspruchs 1 und durch ein Verfahren mit den Merkmalen des Patentanspruchs 13 gelöst. Vorteilhafte Weiterbildungen der Erfindung sind Gegenstand der beigefügten Unteransprüche.

Bislang erfolgt zumindest im Bereich der Nutzfahrzeuge keine Überwachung der parallel zur Induktivität eines durch Pulsweitenmodulation (PWM) angesteuerten Magneten liegenden Freilaufdiode. Ein Ausfall der Freilaufdiode führt zu Fehlerzuständen in einem das zugeordnete Magnetventil enthaltenden Modul. Insbesondere bei mittels PWM angesteuerten Ventilen ist dabei nicht mehr sichergestellt, dass der zugehörige Magnet anzieht. Insbesondere bei systemsichernden Komponenten, wie beispielsweise einem Backup-Ventil eines elektro-pneumatischen Moduls, müssen daher bereits weiter absichernde Maßnahmen wie beispielsweise ein Notbetrieb eingeleitet werden, auch wenn die verbleibende Betriebsbremse weiter funktionsfähig bleibt. Es wird angemerkt, dass das vorgenannte elektro-pneumatische Modul lediglich beispielhaft genannt ist. Die Erfindung ist allgemein bei durch PWM angesteuerten Ventilen, die eine Freilaufdiode benötigen, anwendbar, so beispielsweise auch in Getriebesteuerungen, in Bereichen außerhalb dem speziell der Nutzfahrzeuge, und dergleichen.

Bei Ausfall der Freilaufdiode entsteht durch die Induktivität induziert eine erfassbare Spannungsspitze. Der Erfindung liegt daher der allgemeine Gedanke zugrunde, die bisher übliche Strommessung mit analoger Rückmeldung durch eine kostengünstig und einfach darzustellende Schaltungsanordnung mit digitaler Rückmeldung in Form eines auswertbaren Spannungssignals zu ersetzen. Dazu wird die als Schutzdiode vorgesehene Freilaufdiode bzw. Flyback-Diode in der mittels Pulsweitenmodulation arbeitenden Magnetventil-Ansteuereinrichtung, beispielsweise einer Magnetventil-Treiberstufe oder einer PWM-Ansteuerschaltung für einen Backup-Magneten in einem elektro-pneumatischen Modul eines elektronischen Bremssystems eines Nutzfahrzeugs, überwacht.

Die Überwachung der Freilaufdiode erfolgt mittels einer Schaltungsanordnung, die in konstruktiv einfacherer Ausführung mit Standardbauteilen den bisher hohen Aufwand für die Ventilstrommessung verringert. Die Schaltungsanordnung beinhaltet dazu einen ersten Transistor als Überwachungstransistor und zumindest eine Diode als Überwachungsdiode, welche die Spannung über der Freilaufdiode überwachen und im Fehlerfall, beispielsweise einem zu hohen, einen Defekt anzeigenden Spannungsabfall an der Freilaufdiode, eine Spannungsrückmeldung an einen diese Spannungsrückmeldung auswertenden Mikrocomputer liefern.

Um darüber hinaus auch diese Überwachungsschaltung selbst testen bzw. prüfen zu können, wird ein weiterer, zweiter Transistor als Prüf- oder Testtransistor verschaltet. Wird dieser Testtransistor angesteuert und nach kurzer Zeit wieder gesperrt, welches auch während des Regelbetriebs möglich ist, wird der Überwachungstransistor aktiviert und liefert (auch bei Fehlerfreiheit der Freilaufdiode) die den Fehlerfall anzeigende Spannungsrückmeldung an den Mikrocomputer. Die Schaltungsanordnung insgesamt ist so konfiguriert, dass sie die testweise Spannungsrückmeldung nur dann erzeugt, wenn alle Elemente der Überwachungsschaltung fehlerfrei arbeiten. Wird daher im Testbetrieb die Spannungsrückmeldung erzeugt, kann daran der Mikrocomputer erkennen, dass die Überwachungsschaltung als Ganzes fehlerfrei arbeitet. Wird dagegen im Testbetrieb (in dem davon ausgegangen werden kann, dass die Freilaufdiode in Ordnung ist) die Spannungsrückmeldung nicht erzeugt, beispielsweise weil der Überwachungstransistor selbst schadhaft geworden ist oder weil ein anderes schadhaft gewordenes Element dessen Aktivierung verhindert, kann daraus der Mikrocomputer folgern, dass ein Fehler in der Überwachungsschaltung selbst vorliegt.

Genauer ist die Gesamtschaltungsanordnung dazu ausgelegt, je nach Betriebszustand verschiedene Spannungsrückmeldungen zu generieren, die beispielsweise mittels einer in dem Mikrocomputer bereitgestellten Prüf- und/oder Erfassungsroutine auswertbar sind. Beispielsweise erzeugt die Gesamtschaltungsanordnung bei
- defekter Freilaufdiode, fehlerfrei arbeitender Überwachungsschaltung und fehlerfrei arbeitender Testschaltung eine kontinuierlich ausgebbare Spannungsrückmeldung,
- bei nicht defekter Freilaufdiode, fehlerfrei arbeitender Überwachungsschaltung und fehlerfrei arbeitender Testschaltung eine testweise gepulst getriggerte und innerhalb einer vorbestimmten Zeit abklingende Spannungsrückmeldung (der Test wird in vorbestimmten Zeitabständen, die länger sind als die Abklingzeit der Spannungsrückmeldung, wiederholt durchgeführt),
- bei einem Fehler in der Überwachungsschaltung oder in der Testschaltung keine Spannungsrückmeldung (d.h. wird trotz erfolgter Ansteuerung der Testschaltung keine Spannungsrückmeldung erzeugt, kann auf einen Fehler in wenigstens einer der Überwachungsschaltung und/oder der Testschaltung geschlossen werden, und können tiefer gehende Prüfungen durchgeführt werden).

Die Aufgabe wird somit gelöst durch eine Schaltungsanordnung zur Überwachung einer Freilaufdiode an einem mittels Pulsweitenmodulation angesteuerten Magnetventil, beinhaltend zumindest eine Diode in einem Pulsweitenmodulations-Ansteuerzweig der Schaltungsanordnung; und einen in Emitterschaltung angeordneten Transistor, dessen Emitter mit der Kathode der zumindest einen Diode verbunden ist, wobei die zumindest eine Diode in dem Ansteuerzweig anodenseitig mit einem anodenseitigen Anschluss der Freilaufdiode verbunden in Durchlassrichtung angeordnet ist. Der Transistor ist ein Überwachungstransistor. Die zumindest eine Diode ist dazu angeordnet, die Spannung über der Freilaufdiode zu überwachen und bei einer einen Fehlerfall an der Freilaufdiode anzeigenden Überschreitung ihrer Schwellenspannung den Überwachungstransistor zu aktivieren. Der Überwachungstransistor ist dazu angeordnet, in seinem aktivierten Zustand als ein Überwachungssignal eine Spannungsrückmeldung an einen Mikrocomputer auszugeben.

Bevorzugt ist die zumindest eine Diode dazu angeordnet, in einem Fehlerfall der Freilaufdiode durch eine von dem Magnetventil induzierte Spannung durchlässig zu werden und den Überwachungstransistor zu aktiveren, und ist in diesem Fall das Überwachungssignal ein gegenüber dem nicht aktivierten Zustand des Überwachungstransistors dauerhaft hochpegeliges Signal. Vorteilhaft erzeugt die Schaltungsanordnung aufgrund der PWM-Ansteuerung ein den Fehlerfall eindeutig identifizierendes Signal.

Bevorzugt ist die zumindest eine Diode dazu angeordnet, durch in vorbestimmter Weise Beaufschlagung mit einer Spannung größer als ihre Schwellenspannung durchlässig zu werden und den Überwachungstransistor zu aktiveren, und ist in diesem Fall das Überwachungssignal ein gegenüber dem nicht aktivierten Zustand des Überwachungstransistors zunächst hochpegeliges und dann abklingendes Signal. Vorteilhaft erzeugt die Schaltungsanordnung aufgrund einer separaten Beaufschlagung mit einer Test- oder Prüfspannung bzw. einem entsprechenden Signal, dessen Periodizität sich von der der PWM-Ansteuerung hinreichend unterscheidet, ein die ordnungsgemäße Funktion aller beteiligten Komponenten eindeutig identifizierendes Signal.

Bevorzugt ist anhand des Überwachungssignals in dem aktivierten Zustand des Überwachungstransistors ein Fehlerzustand der Freilaufdiode und/oder der Schaltungsanordnung extern erfassbar. Bei externer Erfassung kann mittels beispielsweise softwarebasierter Auswertung des Überwachungssignalausgangs der Schaltungsanordnung eine Auswertung erfolgen. Es ergeben sich bei unveränderter Schaltungsanordnung Freiheitsgrade durch unterschiedliche Ansteuerung der Eingänge der Schaltungsanordnung, die in entsprechende Routinen abbildbar sind und beispielsweise eine feinere Unterscheidung mehrerer Zustände erlauben.

Bevorzugt beinhaltet die Schaltungsanordnung einen Speicherkondensator, der an einem seiner Anschlüsse mit der Kathode der zumindest einen Diode verbunden ist; und einen zweiten Transistor, dessen Kollektor über einen Ladewiderstand mit dem anderen Anschluss des Speicherkondensators verbunden ist und dessen Emitter mit einem Massepotenzial verbunden ist, wobei der zweite Transistor dazu angeordnet ist, bei seiner Aktivierung den Speicherkondensator über den Ladewiderstand zu laden. Der Speicherkondensator speichert vorteilhaft kurzzeitig die den Überwachungstransistor im Testbetrieb durchschaltende Spannung. Damit können durch entsprechende Ansteuerung des den Speicherkondensator aufladenden Transistors die Frequenz und der Zeitpunkt der Prüfung wahlfrei festgelegt werden.

Bevorzugt ist der Speicherkondensator in Reihe mit einem Vorwiderstand und in dieser Reihenschaltung parallel zu einem Spannungsteiler so zwischen einem Potenzial einer Versorgungsspannung und dem Ansteuerzweig angeordnet, dass sich bei Deaktivierung des zweiten Transistors die Spannung des Speicherkondensators zu der Versorgungsspannung addiert und den Überwachungstransistor zur Erzeugung des Überwachungssignals durchlässig schaltet. Vorteilhaft klingt die gesamte Schaltungsanordnung nach jeder Testauslösung in einen stabilen Gleichgewichtszustand ab, in dem auch ohne Testansteuerung die Funktionsprüfung der Freilaufdiode ohne weiteres erhalten bleibt.

Bevorzugt ist der zweite Transistor dazu angeordnet, durch Beaufschlagung seiner Basis mit einem Steuersignal periodisch aktiviert und deaktiviert zu werden, wobei die periodische Aktivierung und Deaktivierung des zweiten Transistors den Überwachungstransistor in der vorbestimmten Weise periodisch mit der Spannung größer als eine Aktivierungsspannung desselben beaufschlagt, den Überwachungstransistor periodisch aktiviert und deaktiviert, und der Überwachungstransistor das Überwachungssignal periodisch als zunächst hochpegeliges und dann abklingendes Signal erzeugt. Hierdurch wird auf einfache Art und Weise ein eindeutig identifizierbares, periodisch auftretendes Prüfmustersignal erzeugt.

Bevorzugt ist die Schaltungsanordnung dazu konfiguriert, bei Beaufschlagung der Basis des zweiten Transistors mit dem Steuersignal das Überwachungssignal nur dann zu erzeugen, wenn alle Elemente der Schaltungsanordnung fehlerfrei arbeiten. Der besondere Vorteil besteht hier darin, dass zum einen alle Elemente der Überwachungsschaltung in einfacher Konfiguration überwachbar sind, und sich gleichzeitig die Testschaltungsanordnung selbst mit überwacht. Sobald ausgangsseitig kein Signal erzeugt wird, kann ein gesamtes zugrundeliegendes Modul bzw. eine entsprechende Einheit als defekt erkannt und ersetzt werden.

Bevorzugt ist der mit der zumindest einen Diode verbundene Überwachungstransistor ein pnp-Transistor, und ist der zweite Transistor ein npn-Transistor. Vorteilhaft besteht die gesamte Schaltungsanordnung kostengünstig aus gut verfügbaren Standardbauteilen.

Bevorzugt ist eine zweite Diode vorgesehen, die in Durchlassrichtung der zumindest einen Diode im Ansteuerzweig nachgeschaltet und dazu angeordnet ist, den Aktivierungspegel des Überwachungstransistors zu erhöhen. Hierdurch kann vorteilhaft der Störabstand gegenüber Fehlauslösungen erhöht werden.

Eine bevorzugte Verwendung der Schaltungsanordnung erfolgt in einem elektro-pneumatischen Modul eines elektronischen Bremssystems, an dessen Backup-Ventil und/oder einer Getriebesteuereinrichtung für Nutzfahrzeuge. Die Schaltungseinrichtung eignet sich besonders für derartige Anwendungen, da Fehler in diesem Bereich üblicherweise als sicherheitsrelevant eingestuft werden und zu einem unmittelbaren Notbetriebszustand führen. Eine ständige Überwachbarkeit und eine eindeutige und rasche Fehlererkennung und Zuordnung sind daher vorteilhaft. Die kostengünstige Darstellbarkeit erhöht die Wirtschaftlichkeit bei in diesen Bereichen laufenden hohen Stückzahlen.

Ein Verfahren zur Überwachung einer Freilaufdiode an einem mittels Pulsweitenmodulation angesteuerten Magnetventil unter Verwendung zumindest einer Diode, die im Fehlerfall der Freilaufdiode durch aus der Spule des Magnetventils induzierte Spannung durchschaltet und deren Durchschalten Grundlage für die Erzeugung eines den Fehlerfall der Freilaufdiode anzeigenden, dauerhaft hochpegeligen Überwachungssignals bildet, beinhaltet die Schritte des periodisches Beaufschlagens eines Überwachungstransistors mit einer Spannung größer als eine Aktivierungsspannung desselben und dadurch periodischen Durchschaltens des Überwachungstransistors; Erzeugens eines periodisch zunächst hochpegeligen und sodann abklingenden Überwachungssignals auf der Grundlage des periodischen Durchschaltens des Überwachungstransistors; Erfassens eines an einem Überwachungssignalausgang anliegenden Überwachungssignals; und Auswertens des Überwachungssignals, wobei dann, wenn das dauerhaft hochpegelige Überwachungssignal an dem Überwachungssignalausgang erfasst wird, ermittelt wird, dass die Freilaufdiode fehlerhaft ist; wenn das periodisch zunächst hochpegelige und dann abklingende Überwachungssignal an dem Überwachungssignalausgang erfasst wird, ermittelt wird, dass die Freilaufdiode, eine erste Teilschaltungsanordnung zur Überwachung der Freilaufdiode und eine zweite Teilschaltungsanordnung zur Prüfung der ersten Teilschaltungsanordnung ordnungsgemäß arbeiten; und wenn kein Signal an dem Überwachungssignalausgang erfasst wird, ermittelt wird, dass die erste Teilschaltungsanordnung und/oder die zweite Teilschaltungsanordnung fehlerhaft sind/ist. Das Verfahren erlaubt eine eindeutige Erfassbarkeit und Auswertbarkeit bei geringem Rechenaufwand und ist darüber hinaus problemlos an unterschiedliche Vorgaben und Anforderungen anpassbar.

Die Erfindung wird nachstehend anhand bevorzugter Ausführungsbeispiele unter Bezugnahme auf die Zeichnung näher beschrieben. Es zeigen:
- Fig. 1: eine vereinfachte Prinzipdarstellung einer Schaltungsanordnung zur Überwachung einer Freilaufdiode an einem durch Pulsweitenmodulation angesteuerten Magnetventil gemäß einem ersten Ausführungsbeispiel; und
- Fig. 2: eine vereinfachte Gesamtdarstellung der Schaltungsanordnung zur Überwachung einer Freilaufdiode an einem durch Pulsweitenmodulation angesteuerten Magnetventil gemäß einem zweiten Ausführungsbeispiel.

Es wird angemerkt, dass in den Figuren äquivalente oder gleichwirkende Elemente dieselben Bezugszeichen tragen und jeweils nicht nochmals beschrieben werden.

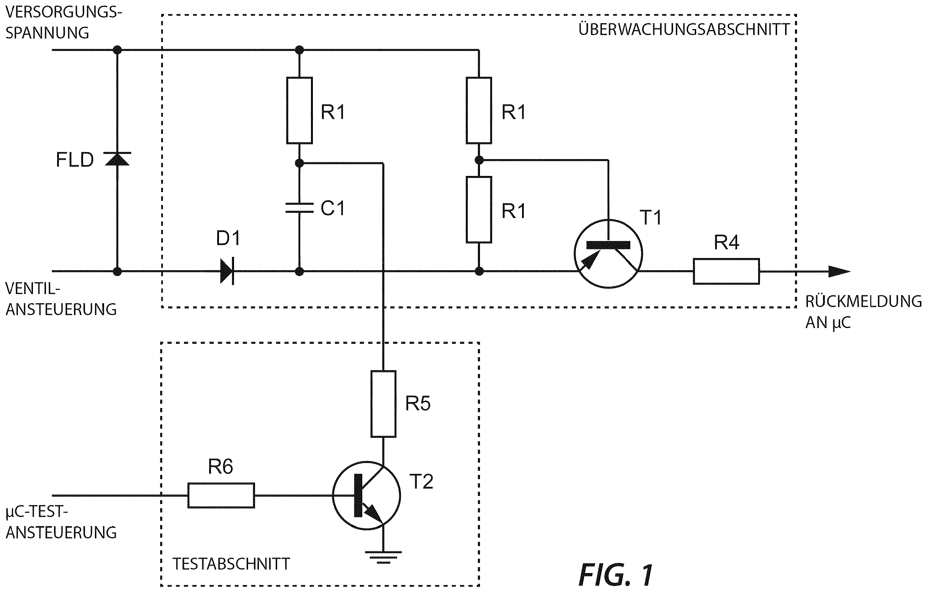

**Fig.** 1 zeigt eine vereinfachte Prinzipdarstellung einer Schaltungsanordnung zur Überwachung einer Freilaufdiode an einem durch Pulsweitenmodulation angesteuerten Magnetventil gemäß einem ersten Ausführungsbeispiel. Die dargestellte Schaltungsanordnung kann gemäß dem hierin beschriebenen Ausführungsbeispiel vorwiegend für eine Magnetventil-Treiberstufe in einer zentralen elektronischen Steuereinheit zur Einsteuerung oder Einregelung eines Bremsdrucks in Radbremszylinder einer elektro-pneumatischen Bremsanlage, insbesondere einer solchen für Nutzfahrzeuge und/oder Nutzfahrzeuge mit einem Anhänger, über mit einem Luftvorrat verbundene Magnetventile vorgesehen sein. Eine Beschränkung hierauf besteht jedoch nicht. Mit der beschriebenen Schaltungsanordnung sind auch Freilaufdioden andernorts überwachbar.

Wie in **Fig. 1** gezeigt, beinhaltet eine Gesamtschaltungsanordnung einen (in der Figur oben dargestellten) Überwachungsabschnitt und einen (in der Figur unten dargestellten) Test- oder Prüfabschnitt. Der Überwachungsabschnitt bildet insoweit eine erste Teilschaltungsanordnung, und der Test- oder Prüfabschnitt bildet insoweit eine zweite Teilschaltungsanordnung. Die Ankopplung des Überwachungsabschnitts an eine (hier einem nicht gezeigten Backup-Magneten bzw. Backup-Ventil zugeordnete) Freilaufdiode FLD erfolgt mittels Parallelschaltung zu dieser, während der Testabschnitt bzw. die zweite Teilschaltungsanordnung wiederum mit einem Anschlusspunkt in dem Überwachungsabschnitt bzw. der ersten Teilschaltungsanordnung verbunden ist.

Übrige Elemente und/oder Konfigurationen der beispielhaft konkreten Magnetventil-Treiberstufe und/oder eines elektro-pneumatischen Moduls eines elektronischen Bremssystems, wie beispielsweise eine konkrete Anzahl von Magnetventilen, d. h. Einlassventilen, Auslassventilen und Backupventilen, die beispielsweise als 2/2-Wege-Magnetventile, d. h. als Magnetventile mit zwei hydraulischen Stellungen und zwei hydraulischen Anschlüssen, ausgeführt sein können, als stromlos offene Magnetventile für einen Druckaufbau in der Bremsanlage (Einlassventile) oder als stromlos geschlossene Magnetventil für einen Druckabbau (Auslassventile) ausgebildet sei können, zumindest ein Relaisventil, und eine Steuereinrichtung bzw. Ansteuereinrichtung, die als Mikrocomputer ausgebildet sein kann, sind auf an sich bekannte Art und Weise vorgesehen und angeordnet und werden daher an dieser Stelle zweckmäßig nicht weiter erläutert oder dargestellt. Angemerkt sei lediglich, dass sich in der Figur linksseitig der Freilaufdiode und parallel dazu verschaltet in der Praxis die mittels PWM angesteuerten Magnetspule(n) befinden würden, und sich rechtsseitig ein geeignet ausgestatteter und ausgelegter Mikrocomputer befinden würde.

Im Einzelnen besteht der Überwachungsabschnitt gemäß der in **Fig. 1** gezeigten Prinzipschaltung aus einem ersten Widerstand R1, der einen hochohmigen Vorwiderstand im Bereich von vorzugsweise 1 bis 10 kOhm ausbildet und in dem vorliegenden Ausführungsbeispiel einem Wert von 4,64 kOhm aufweist, einem ersten Transistor T1, einem zweiten Widerstand R2, der einen Schutzwiderstand an der Basis des Transistors T1 ausbildet und in dem vorliegenden Ausführungsbeispiel einen Wert von 31,6 kOhm aufweist, einem dritten Widerstand R3, der einen Spannungsteilerwiderstand an der Basis des Transistors T1 ausbildet und in dem vorliegenden Ausführungsbeispiel einen Wert von ebenfalls 31,6 kOhm aufweist, einem Kondensator C1, der einen Speicherkondensator zum Filtern von Abschaltspitzen und zur Speicherung einer Testspannung im Bereich von vorzugsweise 1 nF bis 1 µF ausbildet und in dem vorliegenden Ausführungsbeispiel einen Wert von 100 nF aufweist, einem vierten Widerstand R4, der einen Schutzwiderstand an dem Kondensator C1 im Bereich von 10 bis 100 kOhm ausbildet und in dem vorliegenden Ausführungsbeispiel einen Wert von 46,4 kOhm aufweist, und einer Diode D1, die vorzugsweise eine Vielzweck-Hochspannungsdiode für schnell schaltende Anwendungen ist und beispielsweise vom Typ BAS21 sein kann

Nach **Fig. 1** liegt an einem ersten Ende der Freilaufdiode FLD ein Potenzial einer Versorgungsspannung an, und ist ein zweites Ende der Freilaufdiode FLD mit einer (nicht gezeigten) Ventilansteuerung verbunden. Die Freilaufdiode FLD liegt somit parallel zwischen dem Versorgungsspannungspotenzial und der Ventilansteuerung, wobei weiters ihre Kathode zur Versorgungsspannung hin und ihre Anode zur Ventilansteuerung hin liegt. Die Ventilansteuerung selbst erfolgt vorzugs- und beispielsweise mittels Pulsweitenmodulation, beispielsweise auf Grundlage von 0V/5V und 6,25kHz, und Taktung bzw. Unterbrechung zur Masse.

Weiter liegt ein erstes Ende des ersten Widerstands R1 ebenfalls auf dem Potenzial der Versorgungsspannung, und ist ein zweites Ende des ersten Widerstands R1 mit einem ersten Ende des Kondensators C1 verbunden. Ein zweites Ende des Kondensators C1 liegt auf dem Potenzial der Ventilansteuerung bzw. des zu der Ventilansteuerung führenden Leiterpfads. Die Diode D1 ist zwischen dem zweiten Ende des Kondensators C1 und dem zweiten Ende der Freilaufdiode FLD verschaltet, wobei ihre Kathode mit dem zweiten Ende des Kondensators C1 und ihre Anode mit dem zweiten Ende der Freilaufdiode FLD verbunden ist. Ein zweites Ende des zweiten Widerstands R2 ist mit einem ersten Ende des dritten Widerstands R3 verbunden, und ein zweites Ende des dritten Widerstands R3 liegt auf dem Potenzial der Ventilansteuerung.

Der erste Transistor T1 ist ein bipolarer pnp-Transistor beispielsweise des Typs BC857C, dessen Emitter auf dem Potenzial des zu der Ventilansteuerung führenden Leiterpfads liegt und der daher mit dem zweiten Ende des dritten Widerstands R3, dem zweiten Ende des Kondensators C1 und der Kathode der Diode D1 verbunden ist. Der Kollektor des ersten Transistors T1 ist mit einem ersten Ende des vierten Widerstands R4 verbunden, dessen anderes Ende einen Ausgang (Rückmeldeausgang) des Überwachungsabschnitts zu einem (nicht gezeigten) signalverarbeitenden Mikrocomputer bildet. Die Basis des ersten Transistors T1 ist mit dem zweiten Ende des zweiten Widerstands R2 und dem ersten Ende des dritten Widerstands R3, d.h. dem Spannungsteileranschluss des aus dem zweiten Widerstand R2 und dem dritten Widerstand R3 gebildeten Spannungsteilers R2/R3, verbunden.

Der Testabschnitt besteht im Einzelnen aus einem fünften Widerstand R5, der einen Ladewiderstand für den Kondensator C1 ausbildet und in dem vorliegenden Ausführungsbeispiel einen Wert von 6,81 kOhm aufweist, einem zweiten Transistor (Testtransistor) T2, der ein bipolarer npn-Transistor beispielsweise des Typs BC847C sein kann, und einem sechsten Widerstand R6, der einen Schutzwiderstand an der Basis des zweiten Transistors T2 ausbildet und in dem vorliegenden Ausführungsbeispiel einen Wert von 1 kOhm aufweist.

Im Einzelnen ist ein erstes Ende des fünften Widerstands R5 mit dem zweiten Ende des ersten Widerstands R1 und dem ersten Ende des Kondensators C1 verbunden, und ist ein zweites Ende des fünften Widerstands R5 mit dem Kollektor des zweiten Transistors T2 verbunden. Der Emitter des zweiten Transistors T2 ist mit einem Massepotenzial verbunden. Die Basis des zweiten Transistors T2 ist mit einem zweiten Ende des sechsten Widerstands R6 verbunden, dessen erstes Ende mit einem Eingang zur µC-TestAnsteuerung zum Auslösen des Tests bzw. der Prüfung des Überwachungsabschnitts verbunden ist.

Der Überwachungsabschnitt der Gesamtschaltungsanordnung besteht somit aus dem Transistor T1 und der Diode D1, welche die Spannung über der Freilaufdiode FLD überwachen und im Fehlerfall eine Spannungsrückmeldung an den mit dem zweiten Ende des vierten Widerstands R4 verbundenen Mikrocomputer liefern. Ein Fehlerfall kann beispielsweise ein zu hoher Spannungsabfall an der Freilaufdiode FLD sein, der während der PWM-Ansteuerung darauf hinweist, dass die Freilaufdiode FLD nicht durchschaltet bzw. unterbrochen ist. Ein derartiger Fehlerzustand führt aufgrund der PWM-Ansteuerung zu Abschaltspitzen, die in dem vorliegenden Ausführungsbeispiel etwa 60V erreichen können, und ebenso dazu, dass der Magnet des angesteuerten Backup-Ventils nicht mehr angezogen bzw. gehalten wird.

Um diese Überwachungsschaltung wiederum selbst testen zu können, ist der Transistor T2 vorgesehen. Wird dieser einen Testtransistor bildende Transistor T2 angesteuert und nach kurzer Zeit wieder gesperrt, wird der als Überwachungstransistor arbeitende Transistor T1 aktiviert und liefert die Spannungsrückmeldung an den Mikrocomputer (µC), welcher somit erkennen kann, dass die komplette Überwachungsschaltung in Ordnung ist. Nachstehend wird die prinzipielle Funktionsweise der Schaltungsanordnung gemäß dem ersten Ausführungsbeispiel kurz beschrieben.

Im Betriebsfall liegt die Betriebs- oder Versorgungsspannung, die auslegungsabhängig zwischen 12V und 36V betragen kann, zwischen den in der Figur mit "Versorgungsspannung" und "Ventilansteuerung" bezeichneten linksseitigen Enden der Schaltungsanordnung, vorzugsweise gegen Masse an der Ventilansteuerung, an und fließt der Ventilstrom durch die parallel zur Freilaufdiode FLD liegende (nicht dargestellte) Spule des Magnetventils.

Durch die PWM-Ansteuerung im Ventilansteuerzweig wird die Freilaufdiode FLD abwechselnd durchgeschaltet und gesperrt, und fließt der während den Abschaltzeiten in der Spule erzeugte Strom über die parallel zu der Spule liegende und während dieser Zeiten durchschaltende Freilaufdiode FLD ab bzw. klingt im Spule-Dioden-Kreis ab. Der gesamte Teil der ersten Teilschaltungsanordnung rechtsseitig der Freilaufdiode FLD und der Diode D1 ist nahezu stromfrei und liegt auf dem Potenzial der Versorgungsspannung, d.h. an den Widerständen fällt nahezu keine Spannung ab. Das Potenzial der Versorgungsspannung bildet in diesem Fall sozusagen eine virtuelle Masse. Da somit auch die Basis des Transistors T1 spannungsfrei ist, sperrt daher der Transistor T1, und liegt kollektorseitig an dem vierten Widerstand R4 kein bzw. nur ein sehr niedriges Potenzial, das der übernehmende Mikrocomputer als fehlerfreien Betriebsfall auswertet.

Ist der Stromfluss durch die Freilaufdiode FLD aufgrund eines Defekts oder Fehlers derselben unterbrochen, d.h. ist die Freilaufdiode FLD am Durchschalten gehindert, schaltet während jeder PWM-Abschaltzeitspanne die Diode D1 mit gegenüber der Versorgungsspannung erhöhter Spannung durch. Dadurch wird der Kondensator C1 aufgeladen, wobei sich ein Pluspol mit gegenüber der Versorgungsspannung! höherem Potenzial an dessen zweiten (mit der Ventilansteuerleitung verbundenen) Ende und ein Minuspol an dessen ersten (mit dem zweiten Ende des Widerstands R1 verbundenen) Ende ausbildet. In anderen Worten wird die Spannung an dem vorgenannten Pluspol über die Versorgungsspannung angehoben, während der Wert der Spannung an dem Minuspol des Kondensators C1 auf der Versorgungsspannung liegt und sich der vorgenannte Pluspol langsam auf den Wert der Versorgungsspannung entladen kann. Wäre die PWM-Abschaltzeit lang genug, würde sich innerhalb der Schaltungsanordnung wieder ein Gleichgewichtszustand einstellen und sich der Wert der Spannung an dem Pluspol des Kondensators C1 der Versorgungsspannung annähern. In der Praxis jedoch sind die Abschaltzeiten der PWM kurz genug, um den Wert der Spannung an dem Pluspol des Kondensators C1 oberhalb der Versorgungsspannung zu halten.

Aufgrund der so kontinuierlich bestehenden Potenzialdifferenz zwischen der Versorgungsspannung und dem vorgenannten Pluspol des Kondensators C1 entsteht ein Spannungsabfall an dem ersten Widerstand R1 und ebenso an dem durch den zweiten Widerstand R2 und den dritten Widerstand R3 gebildeten Spannungsteiler R2/R3, der genügt, um das Basispotenzial des Transistors T1 anzuheben und diesen durchzuschalten bzw. zu aktivieren. Gleichzeitig wird durch die vorübergehend erhöhte Versorgungsspannung der Emitter bzw. die Spannung an diesem angehoben. Der pnp-Transistor T1 wird leitend, sobald die Emitterspannung höher ist als die Basisspannung. Der Emitterstrom fließt über die Basis des ersten Transistors T1 und teilweise auch über den Widerstand R4 ab bzw. in den Mikrocomputer hinein. Es entsteht ein Spannungsabfall an dem vierten Widerstand R4, der von dem mit diesem verbundenen Mikrocomputer als erhöhter Fehlerspannungswert erfasst wird. In der Praxis ist das zweite Ende an einen geeigneten Erfassungseingang (Spannungserfassungseingang) des Mikrocomputers geschaltet und über einen (nicht dargestellten) Pull-Down-Widerstand mit dem Massepotenzial verbunden. Es wird angemerkt, dass der Kondensator C1 in einem reinen Überwachungsbetrieb unbeachtlich sein kann. Im Fehlerfall dagegen würden bei Fehlen des Kondensators C1 lediglich nadelförmige Impulse an den Erfassungseingang des Mikrocomputers ausgegeben. Aufgrund der Aufladung des Kondensators über die PWM-Impulse wirkt dieser nach Art einer Batterie und puffert eine Spannung auf einen Wert höher als die Versorgungsspannung, wodurch ein gegenüber den lediglich nadelförmigen Impulsen gut erfass- und auswertbares Ausgangssignal erzeugt wird.

Wie vorstehend erwähnt wurde, würde sich bei ausreichend langer PWM-Abschaltzeit aufgrund der abklingenden Stromeinkopplung aus der Spule wieder eine Art stromloser Gleichgewichtszustand innerhalb der ersten Teilschaltungsanordnung einstellen, und würde dadurch der erste Transistor T1 nach einiger Zeit wieder abschalten und die Spannungsrückmeldung an den Mikrocomputer zurücknehmen. Da jedoch bei kontinuierlicher PWM-Ansteuerung die Abschaltzeiten der PWM kurz genug sind, um den Gleichgewichtszustand zu unterbinden, wird der Transistor T1 im Fehlerzustand aufgrund der PWM-Taktung in kurzen Abständen wiederholt aktiviert, bevor die Spannungsrückmeldung aufgrund der schaltungsinternen Ausgleichsvorgänge abklingt, und wird die Spannungsrückmeldung als dauerhaft anliegendes bzw. erfassbares Signal an den Mikrocomputer ausgegeben.

Unabhängig von Zuständen in dem Überwachungsabschnitt erlaubt der Testabschnitt ein Prüfen bzw. Testen der ordnungsgemäßen Funktion des Überwachungsabschnitts. In anderen Worten kann der Überwachungsabschnitt in jedem Betriebszustand mittels des Testabschnitts auf Fehlerfreiheit geprüft werden.

Wird der Testabschnitt über den in der Figur als µC-Testansteuerung bezeichneten Eingang aktiviert, schaltet der zweite Transistor T2 durch und fließt ein Strom über die parallel zur Freilaufdiode FLD liegende Spule, die Diode D1, den Kondensator C1, den fünften Widerstand R5 und den Transistor T2 zur Masse. Vergleichbar zu dem Zustand, der sich im Fehlerfall der Freilaufdiode FLD an dem Kondensator C1 während einer PWM-Abschaltzeitspanne einstellt, wird über den als Ladewiderstand dienenden fünften Widerstand R5 bzw. die sich bei aktivem zweitem Transistor T2 zwischen dem ersten Widerstand R1 und dem fünften Widerstand R5 einstellende Potenzialdifferenz zu der Versorgungsspannung der Kondensator C1 aufgeladen. Sobald der Kondensator C1 aufgeladen ist, ist der sich an diesem ausbildende positive Anschluss bzw. Pluspol an der Kathode der Diode D1 positiver als die Versorgungsspannung, so dass der Überwachungstransistor T1 leitend wird und durchschaltet. In anderen Worten wird der Kondensator C1 in einem Testbetrieb über den zweiten Transistor T2 aufgeladen und addiert bei dem Ausschalten des zweiten Transistors T2 seine Spannung zu der Versorgungsspannung, um darüber den Überwachungstransistor T1 durchleitend zu schalten. Dabei leitet die Diode D1, solange der Kondensator C1 aufgeladen wird, da ihre Anode über die Spule des Magnetventils noch immer auf dem Potenzial der Versorgungsspannung liegt. Auch in diesem Fall bilden sich (im Sinne einer gegenläufigen Logik) am ersten (mit dem ersten Widerstand R1 verbundenen) Anschluss des Kondensators C1 ein Minuspol und an dem zweiten (mit der Ventilansteuerleitung verbundenen) Anschluss des Kondensators C1 ein Pluspol aus, weil im fehlerfreien Normalbetrieb - wie vorstehend beschrieben wurde - der gesamte Teil des Überwachungsabschnitts rechtsseitig der Freilaufdiode FLD und der Diode D1 nahezu stromfrei bzw. auf dem Potenzial der Versorgungsspannung liegt und in sich nahezu potenzialfrei ist. In anderen Worten liegt auch der Ventilansteuerzweig hinter der Diode D1 auf Versorgungsspannungspotenzial, und entsteht durch den Stromfluss über den ersten Widerstand R1 bei aktiviertem zweiten Transistor T2 ein Spannungsabfall an dem ersten Widerstand R1, so dass das Potenzial an dem ersten Anschluss des Kondensators C1 niedriger sein kann als das Potenzial der Versorgungsspannung an der Ventilansteuerleitung.

Wird der zweite Transistor T2 durch Wegnahme seines Aktivierungssignals wieder ausgeschaltet, ist die Spannung an der Kathode der Diode D1 und dem mit dieser verbundenen zweiten Ende des Kondensators C1 größer als die Versorgungsspannung, und wird der erste Transistor T1 leitend. Infolge dessen wird die Spannungsrückmeldung an den Mikrocomputer hochpegelig und als Prüfsignal erfass- und auswertbar.

Der vorstehend beschriebene Funktionstest des Überwachungsabschnitts wird in diesem Ausführungsbeispiel bevorzugt zyklisch wiederholt, beispielsweise durch Ansteuerung des zweiten Transistors T2 mit einem 0V/5V-Rechtecksignal von 100 Hz, und ist unabhängig davon, ob das Magnetventil angesteuert wird oder nicht. Es ergibt sich dadurch im Testbetrieb ein als solches an dem Mikrocomputer erfass- und auswertbares Testmuster von Rückmeldespannungen. Wechseln sich Vorhandensein der Rückmeldespannung und Fehlen der Rückmeldespannung in vorbestimmter Weise ab, kann der Mikrocomputer auf ordnungsgemäße Funktion von Freilaufdiode FLD, Überwachungsabschnitt und Testabschnitt schließen. Im Fehlerfall der Freilaufdiode FLD wird dieses Testmuster von dem dann erzeugten Dauersignal übersteuert, d.h. der Mikrocomputer kann auch bei weiterlaufendem Testabschnitt einen an der Freilaufdiode FLD auftretenden Fehler erkennen. Ist dagegen auch während der Ansteuerung des Testabschnitts keine Rückmeldespannung erfassbar, kann der Mikrocomputer auf einen vorerst nicht näher bestimmbaren Fehler in Freilaufdiode FLD, Überwachungsabschnitt und/oder Testabschnitt schließen.

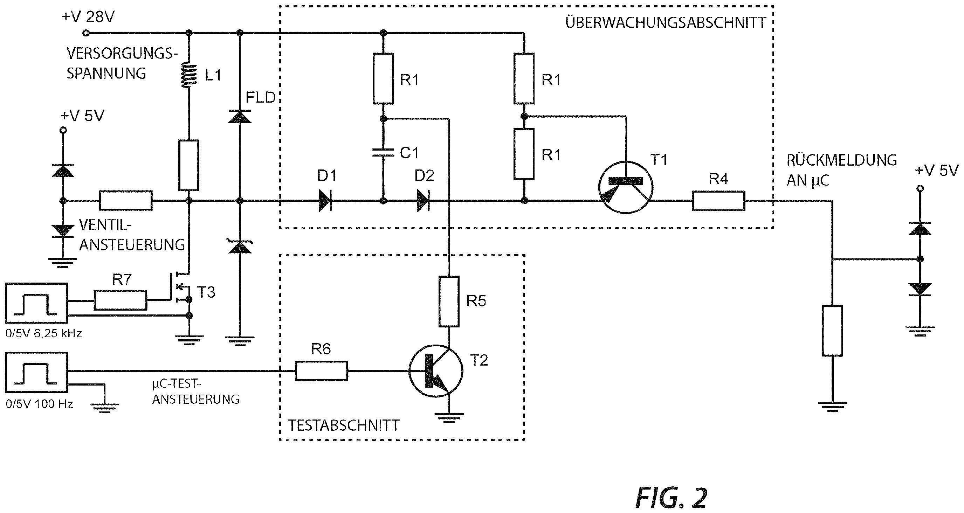

**Fig. 2** zeigt eine vereinfachte, gegenüber der **Fig. 1** erweiterte Gesamtdarstellung der Schaltungsanordnung zur Überwachung einer Freilaufdiode an einem durch Pulsweitenmodulation angesteuerten Magnetventil gemäß einem zweiten Ausführungsbeispiel.

Gegenüber der **Fig.** 1 zeigt die **Fig. 2** genauer eine weitere Beschaltung zur Ansteuerung des Magnetventils und des zweiten Transistors T2 sowie zur Ausleitung der Spannungsrückmeldung an den Mikrocomputer. Zur Ansteuerung des Magnetventils ist insbesondere ein dritter Transistor T3 vorgesehen, der beispielsweise ein n-Kanal-Leistungs-MOSFET des Typs IRF244 oder dergleichen sein kann, der über einen Vorwiderstand R7 mit einem PWM-Signal auf Grundlage von 0V/5V und 6,25 kHz geschaltet wird. Parallel zu dem Transistor T4 ist zur Masse ein Spannungsregler verschaltet, der beispielsweise eine Zenerdiode der 1N53-Serie beinhalten kann. In **Fig. 2** ist ferner die Ansteuerung des zweiten Transistors T2 dargestellt, die kontinuierlich mittels eines Rechteckimpulses auf Grundlage von 0V/5V und 100 Hz erfolgen kann. Ferner kann der Überwachungsabschnitt an Ein- und Ausgängen noch (hier nicht näher beschriebene) Diodenanordnungen zur Schutzbeschaltung beinhalten, beispielsweise hoch leitfähige, schnell schaltende Diodenanordnungen des Typs BAV99.

Darüber hinaus weist das in **Fig. 2** gezeigte zweite Ausführungsbeispiel eine zweite, in dem Ventilansteuerzweig angeordnete Diode D2 auf, die an ihrer Anode mit der Kathode der ersten Diode D1 und dem zweiten Ende des Kondensators C1 und an ihrer Kathode mit dem Emitter des ersten Transistors T1 und dem zweiten Ende des dritten Widerstands R3 verbunden ist. Die zweite Diode D2 kann wie die erste Diode D1 ebenfalls vom Typ BAS21 sein.

Die zweite Diode D2 erhöht auf einfache und kostengünstige Weise den Störabstand des Überwachungsabschnitts, indem sie die Aktivierungsschwelle des Transistors T1 um ihre entsprechende Schwellen- oder Schleusenspannung erhöht. In anderen Worten werden frühzeitige und/oder irrtümliche Auslösungen einer Spannungsrückmeldung, die beispielsweise entstehen können, wenn eine auftretende Abschaltspitze etwa zu schnell und/oder zu groß ist und Signalanteile beinhaltet, die eine einzelne erste Diode D1 bereits durchschalten, obwohl die Freilaufdiode FLD intakt ist, zumindest verringert. In anderen Worten wird durch die zweite Diode D2 die Empfindlichkeit des Überwachungsabschnitts herabgesetzt, ohne ihre Rückmeldeleistung im Fehlerfall zu beeinträchtigen. Eine im Fehlerfall auftretende Spannung an den Dioden D1 und D2 wird jedenfalls ausreichend groß sein, um beide dieser Dioden leitend zu machen und den ersten Transistor T1 zu aktivieren.

In einer Modifikation des ersten und/oder des zweiten Ausführungsbeispiels werden während des Betriebs zusätzlich Testpulse auf den dritten Transistor T3 gegeben. Dadurch wird die Funktion der Freilaufdiode auch während der Nichtansteuerung der Spule des Magnetventils prüfbar, bei einem Nutzfahrzeug beispielsweise in einem Betriebszustand, in welchem die Betriebsbremsanlage als solche außer Betrieb ist, etwa bei lediglich eingeschalteter Zündung oder während Messungen durch ein Diagnosegerät. Diese stromlose Messung ist mit der bekannten Stromrückmeldung des Spulenstroms nicht möglich.

Wie vorstehend beschrieben wurde, beinhaltet eine Schaltungsanordnung zur Überwachung einer Freilaufdiode an einem mittels Pulsweitenmodulation angesteuerten Magnetventil zumindest eine Diode D1 in einem Pulsweitenmodulations-Ansteuerzweig der Schaltungsanordnung und einen Überwachungstransistor T1. Die Diode D1 in dem Ansteuerzweig ist mit der zu überwachenden Freilaufdiode FLD verbunden in Durchlassrichtung angeordnet und löst bei einer Überschreitung ihrer Schwellenspannung, beispielsweise einem Fehlerfall der Freilaufdiode FLD, eine Aktivierung des Überwachungstransistors T1 aus, der sodann ein Überwachungssignal oder Fehlersignal erzeugt und ausgibt. In einem Prüfbetrieb wird der Überwachungstransistor T1 unabhängig von übrigen Zuständen in der Schaltungsanordnung periodisch angesteuert und durchgeschaltet und dadurch ein periodisches Überwachungssignal erzeugt, das an denselben Ausgang geführt wird. Wenn dort ein dauerhaft hochpegeliges Überwachungssignal erfasst wird, wird ermittelt, dass die Freilaufdiode FLD fehlerhaft ist. Wenn ein periodisch hochpegeliges und dann abklingendes Überwachungssignal erfasst wird, wird ermittelt, dass die Freilaufdiode FLD, eine erste Teilschaltungsanordnung zur Überwachung der Freilaufdiode FLD und eine zweite Teilschaltungsanordnung zur Prüfung der ersten Teilschaltungsanordnung ordnungsgemäß arbeiten. Wenn kein Signal erfasst wird, wird ein Fehler in den Teilschaltungsanordnungen ermittelt.

Insgesamt entspricht die erfindungsgemäße Lösung somit zum einen den zunehmenden Forderungen, mehr und mehr Komponenten überprüfbar zu machen und in routinemäßige Überwachungen einzubeziehen, und kann kostengünstig und mit einfachem Aufbau bei allen mittels Pulsweitenmodulation angesteuerten Magnetventilen, die eine Freilaufdiode benötigen, eine teure und aufwändige Ventilstrommessung ersetzen. Insbesondere vorteilhaft sind darüber hinaus die Selbstüberwachung auch während laufenden Betriebs der zu überwachenden Freilaufdiode, sowie die erzielbare Überwachbarkeit der zu überwachenden Freilaufdiode auch außerhalb von Zeiten der Ansteuerung des Magnetventils.

### BEZUGSZEICHENLISTE

- R1: erster Widerstand
- R2: zweiter Widerstand
- R3: dritter Widerstand
- R4: vierter Widerstand
- R5: fünfter Widerstand
- R6: sechster Widerstand
- R7: Vorwiderstand
- D1, D2: Dioden
- FLD: Freilaufdiode
- C1: Kondensator
- T1: Überwachungstransistor
- T2: zweiter Transistor
- T3: dritter Transistor
- T4: vierter Transistor
- µC: Mikrocomputer

## Patentansprüche

1. Schaltungsanordnung zur Überwachung einer Freilaufdiode an einem mittels Pulsweitenmodulation angesteuerten Magnetventil, beinhaltend
- zumindest eine Diode (D1) in einem Pulsweitenmodulations-Ansteuerzweig der Schaltungsanordnung; und
- einen in Emitterschaltung angeordneten Transistor (T1), dessen Emitter mit der Kathode der zumindest einen Diode (D1) verbunden ist, wobei
- die zumindest eine Diode (D1) in dem Ansteuerzweig anodenseitig mit einem anodenseitigen Anschluss der Freilaufdiode (FLD) verbunden in Durchlassrichtung angeordnet ist,
**dadurch gekennzeichnet, dass**
der Transistor (T1) ein Überwachungstransistor ist;
die zumindest eine Diode (D1) dazu angeordnet ist, die Spannung über der Freilaufdiode (FLD) zu überwachen und bei einer einen Fehlerfall an der Freilaufdiode (FLD) anzeigenden Überschreitung ihrer Schwellenspannung den Überwachungstransistor (T1) zu aktivieren; und
- der Überwachungstransistor (T1) dazu angeordnet ist, in seinem aktivierten Zustand als ein Überwachungssignal eine Spannungsrückmeldung an einen Mikrocomputer auszugeben.

2. Schaltungsanordnung nach Anspruch 1,
**dadurch gekennzeichnet, dass**
die zumindest eine Diode (D1) dazu angeordnet ist, in einem Fehlerfall der Freilaufdiode durch eine von dem Magnetventil induzierte Spannung durchlässig zu werden und den Überwachungstransistor (T1) zu aktiveren, und in diesem Fall das Überwachungssignal ein gegenüber dem nicht aktivierten Zustand des Überwachungstransistors (T1) dauerhaft hochpegeliges Signal ist.

3. Schaltungsanordnung nach Anspruch 2,
**dadurch gekennzeichnet, dass**
die zumindest eine Diode (D1) dazu angeordnet ist, durch in vorbestimmter Weise Beaufschlagung mit einer Spannung größer als ihre Schwellenspannung durchlässig zu werden und den Überwachungstransistor (T1) zu aktiveren, und in diesem Fall das Überwachungssignal ein gegenüber dem nicht aktivierten Zustand des Überwachungstransistors (T1) zunächst hochpegeliges und dann abklingendes Signal ist.

4. Schaltungsanordnung nach einem Anspruch 3,
**dadurch gekennzeichnet, dass**
anhand des Überwachungssignals in dem aktivierten Zustand des Überwachungstransistors (T1) ein Fehlerzustand der Freilaufdiode und/oder der Schaltungsanordnung extern erfassbar ist.

5. Schaltungsanordnung nach einem der vorangehenden Ansprüche, **gekennzeichnet durch**
- einen Speicherkondensator (C1), der an einem seiner Anschlüsse mit der Kathode der zumindest einen Diode (D1) verbunden ist; und
- einen zweiten Transistor (T2), dessen Kollektor über einen Ladewiderstand (R5) mit dem anderen Anschluss des Speicherkondensators (C1) verbunden ist und dessen Emitter mit einem Massepotenzial verbunden ist, wobei
- der zweite Transistor (T2) dazu angeordnet ist, bei seiner Aktivierung den Speicherkondensator (C1) über den Ladewiderstand (R5) zu laden.

6. Schaltungsanordnung nach Anspruch 5, **dadurch gekennzeichnet, dass**
der Speicherkondensator (C1) in Reihe mit einem Vorwiderstand (R1) und in dieser Reihenschaltung parallel zu einem Spannungsteiler (R2, R3) so zwischen einem Potenzial einer Versorgungsspannung und dem Ansteuerzweig angeordnet ist, dass sich bei Deaktivierung des zweiten Transistors (T2) die Spannung des Speicherkondensators (C1) zu der Versorgungsspannung addiert und den Überwachungstransistor (T1) zur Erzeugung des Überwachungssignals durchlässig schaltet.

7. Schaltungsanordnung nach einem der Ansprüche 3 bis 6,
**dadurch gekennzeichnet, dass**
der zweite Transistor (T2) dazu angeordnet ist, durch Beaufschlagung seiner Basis mit einem Steuersignal periodisch aktiviert und deaktiviert zu werden, wobei die periodische Aktivierung und Deaktivierung des zweiten Transistors (T2) den Überwachungstransistor (T1) in der vorbestimmten Weise periodisch mit der Spannung größer als eine Aktivierungsspannung desselben beaufschlagt, den Überwachungstransistor (T1) periodisch aktiviert und deaktiviert, und der Überwachungstransistor (T1) das Überwachungssignal periodisch als zunächst hochpegeliges und dann abklingendes Signal erzeugt.

8. Schaltungsanordnung nach Anspruch 7,
**dadurch gekennzeichnet, dass**
die Schaltungsanordnung dazu konfiguriert ist, bei Beaufschlagung der Basis des zweiten Transistors (T2) mit dem Steuersignal das Überwachungssignal nur dann zu erzeugen, wenn alle Elemente der Schaltungsanordnung fehlerfrei arbeiten.

9. Schaltungsanordnung nach einem der vorangehenden Ansprüche,
**dadurch gekennzeichnet, dass**
der mit der zumindest einen Diode (D1) verbundene Überwachungstransistor (T1) ein pnp-Transistor ist.

10. Schaltungsanordnung nach einem der Ansprüche 5 bis 9,
**dadurch gekennzeichnet, dass**
der zweite Transistor (T2) ein npn-Transistor ist.

11. Schaltungsanordnung nach einem der vorangehenden Ansprüche,
**dadurch gekennzeichnet, dass**
eine zweite Diode (D2) vorgesehen ist, die in Durchlassrichtung der zumindest einen Diode (D1) im Ansteuerzweig nachgeschaltet und dazu angeordnet ist, den Aktivierungspegel des Überwachungstransistors (T1) zu erhöhen.

12. Verwendung der Schaltungsanördnung nach einem der vorangehenden Ansprüche in einem elektro-pneumatischen Modul eines elektronischen Bremssystems und/oder einer Getriebesteuereinrichtung für Nutzfahrzeuge.

13. Verfahren zur Überwachung einer Freilaufdiode an einem mittels Pulsweitenmodulation angesteuerten Magnetventil unter Verwendung zumindest einer Diode (D1; D1, D2), die im Fehlerfall der Freilaufdiode (FLD) durch aus der Spule des Magnetventils induzierte Spannung durchschaltet und deren Durchschalten Grundlage für die Erzeugung eines den Fehlerfall der Freilaufdiode (FLD) anzeigenden, dauerhaft hochpegeligen Überwachungssignals bildet,
**gekennzeichnet durch die Schritte:**
- periodisches Beaufschlagen eines Überwachungstransistors (T1) mit einer sich aus dem Durchschalten der Diode ergebenden Spannung größer als eine Aktivierungsspannung desselben und dadurch periodisches Durchschalten des Überwachungstransistors (T1);
- Erzeugen eines periodisch zunächst hochpegeligen und sodann abklingenden Überwachungssignals auf der Grundlage des periodischen Durchschaltens des Überwachungstransistors (T1);
- Erfassen eines an einem Überwachungssignalausgang anliegenden Überwachungssignals; und
- Auswerten des Überwachungssignals, wobei dann,
- wenn das dauerhaft hochpegelige Überwachungssignal an dem Überwachungssignalausgang erfasst wird, ermittelt wird, dass die Freilaufdiode (FLD) fehlerhaft ist;
- wenn das periodisch zunächst hochpegelige und dann abklingende Überwachungssignal an dem Überwachungssignalausgang erfasst wird, ermittelt wird, dass die Freilaufdiode (FLD), eine erste Teilschaltungsanordnung zur Überwachung der Freilaufdiode (FLD) und eine zweite Teilschaltungsanordnung zur Prüfung der ersten Teilschaltungsanordnung ordnungsgemäß arbeiten; und
- wenn kein Signal an dem Überwachungssignalausgang erfasst wird, ermittelt wird, dass die erste Teilschaltungsanordnung und/oder die zweite Teilschaltungsanordnung fehlerhaft sind/ist.

## Claims

1. Circuit arrangement for monitoring a freewheeling diode at a solenoid valve actuated by means of pulse width modulation, comprising
- at least one diode (D1) in a pulse-width-modulation actuation branch of the circuit arrangement; and
- a transistor (T1) arranged in emitter connection, the emitter of said transistor being connected to the cathode of the at least one diode (D1), wherein
- the anode side of the at least one diode (D1) in the actuation branch is arranged so as to be connected in the forward direction to an anode-side terminal of the freewheeling diode (FLD)
**characterised in that**
the transistor (T1) is a monitoring transistor;
the at least one diode (D1) is arranged to monitor the voltage of the freewheeling diode (FLD) and to activate the monitoring transistor (T1) when the threshold voltage of said diode is exceeded, indicating a fault in the freewheeling diode (FLD); and
- the monitoring transistor (T1) is arranged to emit a voltage feedback as a monitoring signal to a microcomputer in its activated state.

2. Circuit arrangement according to claim 1,
**characterised in that**
in the event of a fault in the freewheeling diode, the at least one diode (D1) is arranged become conducting by a voltage induced by the solenoid valve and to activate the monitoring transistor (T1), and, in this case, the monitoring signal is a continuously high-level signal compared to the non-activated state of the monitoring transistor (T1).

3. Circuit arrangement according to claim 2,
**characterised in that**
the at least one diode (D1) is arranged to become conducting by having a voltage greater than its threshold voltage applied to it in a predetermined manner and to activate the monitoring transistor (T1), and, in this case, the monitoring signal is an initially high-level signal and then a decaying signal compared to the non-activated state of the monitoring transistor (T1).

4. Circuit arrangement according to claim 3,
**characterised in that**
a fault state of the freewheeling diode and/or of the circuit arrangement can be detected externally using the monitoring signal in the activated state of the monitoring transistor (T1).

5. Circuit arrangement according to any of the preceding claims, **characterised by**
- a storage capacitor (C1), which is connected at one of its terminals to the cathode of the at least one diode (D1); and
- a second transistor (T2), the collector of which is connected to the other terminal of the storage capacitor (C1) by way of a charging resistor (R5) and the emitter of which is connected to a ground potential, wherein
- the second transistor (T2) is arranged to charge the storage capacitor (C1) by way of the charging resistor (R5) when said second transistor is activated,

6. Circuit arrangement according to claim 5,
**characterised in that**
the storage capacitor (C1) is connected in series with a series resistor (R1) and, in said series circuit, is arranged in parallel with a voltage divider (R2, R3) in such a way between a potential of a supply voltage and the actuation branch that, when the second transistor (T2) is deactivated, the voltage of the storage capacitor (C1) is added to the supply voltage and turns on the monitoring transistor (T1) to generate the monitoring signal.

7. Circuit arrangement according to any of claims 3 to 6,
**characterised in that**
the second transistor (T2) is arranged to be activated and deactivated periodically by having a control signal applied to its base, wherein the periodic activation and deactivation of the second transistor (T2) periodically applies the voltage greater than an activation voltage thereof to the monitoring transistor (T1) in the predetermined manner, periodically activates and deactivates the monitoring transistor (T1), and the monitoring transistor (T1) periodically generates the monitoring signal as an initially high-level and then decaying signal.

8. Circuit arrangement according to claim 7,
**characterised in that**
the circuit arrangement is configured, when the control signal is applied to the base of the second transistor (T2), to generate the monitoring signal only when all the elements of the circuit arrangement are operating in a fault-free manner.

9. Circuit arrangement according to any of the preceding claims,
**characterised in that**
the monitoring transistor (T1) connected to the at least one diode (D1) is a pnp transistor.

10. Circuit arrangement according to any of claims 5 to 9,
**characterised in that**
the second transistor (T2) is an npn transistor.

11. Circuit arrangement according to any of the preceding claims,
**characterised in that**
a second diode (D2) is provided, which is connected in the forward direction downstream of the at least one diode (D1) in the actuation branch and is arranged to increase the activation level of the monitoring transistor (T1).

12. Use of the circuit arrangement according to any of the preceding claims in an electropneumatic module of an electronic brake system and/or a transmission control device for commercial vehicles.

13. Method for monitoring a freewheeling diode at a solenoid valve actuated by means of pulse width modulation using at least one diode (D1; D1, D2), which turns on in the event of a fault in the freewheeling diode (FLD) by voltage induced from the coil of the solenoid valve and the turning-on of which diode forms the basis for the generation of a continuously high-level monitoring signal that indicates the event of a fault in the freewheeling diode (FLD),
**characterised by the following steps:**
- periodically applying a voltage - resulting from the turning-on of the diode - greater than an activation voltage of the monitoring transistor (T1) to said monitoring transistor and thereby periodically turning on the monitoring transistor (T1);
- generating a periodically initially high-level and then decaying monitoring signal on the basis of the periodic turning-on of the monitoring transistor (T1);
- detecting a monitoring signal applied to a monitoring signal output; and
- evaluating the monitoring signal, wherein,
- if the continuously high-level monitoring signal is detected at the monitoring signal output, it is identified that the freewheeling diode (FLD) is faulty;
- if the periodically initially high-level and then decaying monitoring signal is detected at the monitoring signal output, it is identified that the freewheeling diode (FLD), a first sub-circuit arrangement for monitoring the freewheeling diode (FLD) and a second sub-circuit arrangement for checking the first sub-circuit arrangement are operating correctly; and
- if no signal is detected at the monitoring signal output, it is identified that the first sub-circuit arrangement and/or the second sub-circuit arrangement are/is faulty.

## Revendications

1. Montage de contrôle d'une diode de roue libre sur une électrovanne commandée au moyen d'une modulation de largeur d'impulsion, comportant :
- au moins une diode (D1) dans une branche de commande de modulation de largeur d'impulsion du montage ; et
- un transistor (T1), qui est monté dans un circuit d'émetteur et dont l'émetteur est relié à la cathode de la au moins une diode (D1), dans lequel
- la au moins une diode (D1) est montée dans le sens passant en étant reliée, dans la branche de commande du côté de l'anode, à une borne du côté de l'anode de la diode (FLD) de roue libre,
**caractérisé en ce que**
le transistor (T1) est un transistor de contrôle ;
la au moins une diode (D1) est montée pour contrôler la tension aux bornes de la diode (FLD) de roue libre et, s'il se produit un dépassement, indiquant un cas de défaut de la diode (FLD) de roue libre, de sa tension de seuil, pour activer le transistor (T1) de contrôle ; et
- le transistor (T1) de contrôle est monté pour, dans son état activé, donner à un microordinateur un rétro message de tension comme signal de contrôle.

2. Montage suivant la revendication 1,
**caractérisé**
**en ce que** la au moins une diode (D1) est montée pour devenir, dans un cas de défaut de la diode de roue libre, passante à une tension induite par l'électrovanne et pour activer le transistor (T1) de contrôle et, dans ce cas, le signal de contrôle est un signal de niveau haut en permanence par rapport à l'état non activé du transistor (T1) de contrôle.

3. Montage suivant la revendication 2,
**caractérisé**
**en ce que** la au moins une diode (D1) est montée pour devenir passante en étant soumise d'une façon définie à l'avance à une tension plus haute que sa tension de seuil et pour activer le transistor (T1) de contrôle et, dans ce cas, le signal de contrôle est, par rapport à l'état non activé du transistor (T1) de contrôle, un signal d'abord de niveau haut et ensuite décroissant.

4. Montage suivant la revendication 3,
**caractérisé**
**en ce qu'**à l'aide du signal de contrôle, dans l'état activé du transistor (T1) de contrôle, un état de défaut de la diode de roue libre et/ou du montage peut être détecté de l'extérieur.

5. Montage suivant l'une des revendications précédentes, **caractérisé par**
- un condensateur (C1) accumulateur, qui est connecté à l'une de ses bornes à la cathode de la au moins une diode (D1) ; et
- un deuxième transistor (T2), dont le collecteur est connecté par une résistance (R5) de charge à l'autre borne du condensateur (C1) accumulateur et dont l'émetteur est mis à un potentiel de masse, dans lequel
- le deuxième transistor (T2) est monté pour charger, lors de son activation, le condensateur (C1) accumulateur par l'intermédiaire de la résistance (R5) de charge.

6. Montage suivant la revendication 5,
**caractérisé en ce que**
le condensateur (C1) accumulateur est monté en série avec un résistance (R1) série et, dans ce circuit série en parallèle à un diviseur (R2, R3) de tension, entre un potentiel d'une tension d'alimentation et la branche de commande, de manière à ce que, lorsque le deuxième transistor (T2) est désactivé, la tension du condensateur (C1) accumulateur s'additionne à la tension d'alimentation et rend passant le transistor (T1) de contrôle pour la production du signal de contrôle.

7. Montage suivant l'une des revendications 3 à 6,
**caractérisé en ce que**
le deuxième transistor (T2) est monté pour être activé et désactivé périodiquement en soumettant sa base à un signal de commande, l'activation et la désactivation périodique du deuxième transistor (T2) soumettant le transistor (T1) de contrôle de la façon définie à l'avance périodiquement à la tension plus haute qu'une tension d'activation de celui-ci, activant et désactivant périodiquement le transistor (T1) de contrôle, et le transistor (T1) de contrôle produit le signal de contrôle périodiquement sous la forme d'abord d'un signal de niveau haut et ensuite d'un signal décroissant.

8. Montage suivant la revendication 7,
**caractérisé en ce que**
le montage est configuré pour, lorsque la base du deuxième transistor (T2) est soumise au signal de commande, produire le signal de contrôle seulement lorsque tous les éléments du montage travaillent sans défaut.

9. Montage suivant l'une des revendications précédentes,
**caractérisé en ce que**
le transistor (T1) de contrôle connecté à la au moins une diode (D1) est un transistor pnp.

10. Montage suivant l'une des revendications 5 à 9,
**caractérisé en ce que**
le deuxième transistor (T2) est un transistor npn.

11. Montage suivant l'une des revendications précédentes,
**caractérisé en ce que**
il est prévu une deuxième diode (D2) qui, dans le sens passant de la au moins une diode (D1), est montée en aval dans la branche de commande et est montée pour élever le niveau d'activation du transistor (T1) de contrôle.

12. Utilisation du montage suivant l'une des revendications précédentes, dans un module électropneumatique d'un système électronique de freinage et/ou dans un dispositif de commande de transmission de véhicules utilitaires.

13. Procédé de contrôle d'une diode de roue libre sur une électrovanne commandée au moyen d'une modulation de largeur d'impulsion en utilisant au moins une diode (D1 ; D1, D2) qui, dans le cas d'un défaut de la diode (FLD) de roue libre, est rendue passante à une tension induite à partir de la bobine de l'électrovanne et dont le fait qu'elle soit rendue passante forme la raison de base pour la production d'un signal de contrôle de niveau haut en permanence, indiquant le cas de défaut de la diode (FLD) de roue libre,
**caractérisé par les stades :**
- soumission périodique d'un transistor (T1) de contrôle à une tension provenant du fait que la diode est passante, plus haute qu'une tension d'activation de celui-ci, et ainsi le transistor (T1) de contrôle est rendu passant périodiquement ;
- production d'un signal de contrôle périodiquement, d'abord de niveau haut et ensuite décroissant sur la base du fait que le transistor (T1) de contrôle est rendu passant périodiquement ;
- détection d'un signal de contrôle s'appliquant à une sortie de signal de contrôle ; et
- analyse du signal de contrôle, dans lequel,
- si l'on détecte le signal de contrôle de niveau haut en permanence à la sortie du signal de contrôle, on détermine que la diode (FLD) de roue libre est défectueuse,
- si l'on détecte le signal de contrôle périodiquement, d'abord de niveau haut et ensuite décroissant à la sortie du signal de contrôle, on détermine que la diode (FLD) de roue libre, un premier montage partiel de contrôle de la diode (FLD) de roue libre et un deuxième montage partiel de contrôle du premier montage partiel travaillent conformément aux prescriptions ; et
- si l'on ne détecte pas de signal à la sortie du signal de contrôle, on détermine que le premier montage partiel et/ou le deuxième montage sont/est défectueux.
